(19) Europäisches Patentamt
European Patent Office
Office européen des brevets

(11) **EP 0 988 407 B1**

(12) **EUROPÄISCHE PATENTSCHRIFT**

(45) Veröffentlichungstag und Bekanntmachung des Hinweises auf die Patenterteilung:
**26.05.2004 Patentblatt 2004/22**

(21) Anmeldenummer: **98920439.1**

(22) Anmeldetag: **27.05.1998**

(51) Int Cl.[7]: **C23C 16/50**

(86) Internationale Anmeldenummer:
**PCT/CH1998/000221**

(87) Internationale Veröffentlichungsnummer:
**WO 1998/058099 (23.12.1998 Gazette 1998/51)**

(54) **VERFAHREN ZUR HERSTELLUNG VON WERKSTÜCKEN, DIE MIT EINER EPITAKTISCHEN SCHICHT BESCHICHTET SIND**

METHOD FOR PRODUCING COATED WORKPIECES, WHICH ARE COATED WITH AN EPITACTIC LAYER

PROCEDE DE FABRICATION DE PIECES ENDUITES D'UNE COUCHE DE QUALITE POUR EPITAXIE

(84) Benannte Vertragsstaaten:
**AT BE CH DE ES FR GB IE IT LI NL SE**

(30) Priorität: **13.06.1997 CH 144597**

(43) Veröffentlichungstag der Anmeldung:
**29.03.2000 Patentblatt 2000/13**

(60) Teilanmeldung:
**04004051.1**

(73) Patentinhaber: **Unaxis Trading AG**
**9477 Trübbach (CH)**

(72) Erfinder:
 • **VON KÄNEL, Hans**
 **CH-8304 Wallisellen (CH)**
 • **ROSENBLAD, Carsten**
 **Ch-8049 Zürich (CH)**
 • **RAMM, Jürgen**
 **CH-9475 Sevelen (CH)**

(74) Vertreter: **Troesch Scheidegger Werner AG**
**Patentanwälte**
**Postfach**
**8032 Zürich (CH)**

(56) Entgegenhaltungen:
DE-A- 3 614 384      GB-A- 2 219 578
US-A- 4 443 488      US-A- 5 554 222

 • SHANFIELD S.R.: "PLASMA-ENHANCED CHEMICAL VAPOR DEPOSITION OF EPITAXIAL SILICON FROM SILANE" EXTENDED ABSTRACTS, Bd. 83-1, 1983, Seiten 230-231, XP002056339 US
 • MANTEI T.D ET AL: "LOW TEMPERATURE DEPOSITIONOF MICROCRYSTALLINE SILICON IN A MULTIPOLAR PLASMA" EXTENDED ABSTRACTS, Bd. 85, Nr. 2, 1985, Seiten 396-397, XP002056340 US
 • STIEGLER J ET AL: "PLASMA-ASSISTED CVD OF DIAMOND FILMS BY HOLLOW CATHODE ARC DISCHARGE" DIAMOND AND RELATED MATERIALS, Bd. 2, Nr. 2 / 04, 31. März 1993, Seiten 413-416, XP000360820
 • SOLOMON S J: "Silicon from silane through plasma deposition" FIFTEENTH IEEE PHOTOVOLTAIC SPECIALISTS CONFERENCE - 1981, KISSIMMEE, FL, USA, 12-15 MAY 1981, Seiten 569-571, XP002056341 1981, NEW YORK, NY, USA, IEEE, USA
 • KORNER N ET AL: "Hydrogen plasma chemical cleaning of metallic substrates and silicon wafers" 22ND INTERNATIONAL CONFERENCE ON METALLURGICAL COATING AND THIN FILMS, SAN DIEGO, CA, USA, 24-28 APRIL 1995, Bd. 77, Nr. 1-3, Seiten 731-737, XP002056342 ISSN 0257-8972, SURFACE AND COATINGS TECHNOLOGY, DEC. 1995, ELSEVIER, SWITZERLAND

- **SINGH B ET AL: "HOLLOW CATHODE PLASMA ASSISTED CHEMICAL VAPOR DEPOSITION OF DIAMOND" APPLIED PHYSICS LETTERS, Bd. 52, Nr. 20, 16. Mai 1988, Seiten 1658-1660, XP000119536**
- **PANDE K.P ET AL: "LOW TEMPERATURE PLASMA-ENHANCED EPITAXY OF GAAS" JOURNAL OF THE ELECTROCHEMICAL SOCIETY, Bd. 131, Nr. 6, Juni 1984, Seiten 1357-1359, XP002056343 US**

Bemerkungen:
Die Akte enthält technische Angaben, die nach dem Eingang der Anmeldung eingereicht wurden und die nicht in dieser Patentschrift enthalten sind.

**Beschreibung**

Die vorliegende Erfindung betrifft Verfahren zur Herstellung von Werkstücken, die mit einer epitaktischen Schicht beschichtet sind.

Dabei geht die vorliegende Erfindung von Problemen aus, die sich bei der Herstellung dünner Schichten mit CVD- und PECVD-Verfahren ergeben. Die dabei erfindungsgemäss gemachten Erkenntnisse lassen sich insbesondere auf die Herstellung von Halbleiterschichten, wie von Solarzellen oder von modulationsdotierten FET's oder von heterobipolaren Transistoren, übertragen.

Dünne Halbleiterfilme werden entweder in einkristalliner Form, d.h. epitaktisch, auf ein ebenfalls einkristallines Substrat, wie ein Siliziumsubstrat abgeschieden, oder aber in polykristalliner Form oder amorpher Form auf polykristalline oder amorphe Substrate, z.B. auf Glas. Im folgenden wird die Erfindung vor allem mit Bezug auf die Herstellung Silizium- und/oder Germanium-beschichteter bzw. Galium-beschichteter Substrate beschrieben.

Bekannte Verfahren zur Abscheidung epitaktischer Halbleiterfilme sind:

- Molekularstrahl-Epitaxie, MBE (Molecular Beam Epitaxy)

- Thermo-Chemische Gasphasenabscheidung, CVD (Chemical Vapour Deposition)

- Remote-Plasmaunterstützte CVD-Verfahren mit DC- oder Hf-Entladung, RPECVD (Remote-Plasma-Enhanced CVD)

- Mikrowellen-Plasmaunterstützte chemische Gasphasenabscheidung und ECRCVD (Electron-Cyclotron-Resonance-Plasma-Assisted CVD)

Beim CVD-erfahren handelt es sich um einen Sammelbegriff einer grossen Anzahl von thermischen Abscheidungsmethoden, die sich entweder durch den Aufbau der zugeordneten Apparaturen unterscheiden, oder durch deren Betriebsart. So kann z.B. ein CVD-Verfahren bei Normal-Atmosphärendruck durchgeführt werden, oder aber bei viel kleineren Drücken bis hinunter ins Gebiet des Ultra-Hochvakuums. Es kann hierzu auf (1) verwiesen werden, sowie auf (2).

In der kommerziellen Produktion von epitaktischen Si-Schichten ist ausschliesslich CVD gebräuchlich. Die verwendeten Reaktivgase sind dabei siliziumhaltige Gase, z.B. Chlorsilane, $SiCl_4$, $Si_3HCl$ und $SiH_2Cl_2$ sowie Silane, z.B. $SiH_4$ oder $Si_2H_6$. Charakteristisch für die Standard-CVD-Verfahren sind die hohen Abscheide-Temperaturen in der Grössenordnung von 1000°C und mehr, sowie Drücke von typischerweise 20 mbar bis 1000 mbar, d.h. bis Normal-Atmosphärendruck.

Je nach Prozessbedingungen können damit Beschichtungsraten von mehreren μm pro Minute erzielt werden, entsprechend mehreren 100 Å/sec, wozu wiederum auf (1) verwiesen sei.

Niederdruck-chemische Gasphasenabscheidung (LPCVD, Low Pressure Chemical Vapour Deposition, gleichbedeutend mit LPVPE, Low-Pressure Vapour Phase Epitaxy) findet dagegen bei Drücken unter 1 mbar statt und erlaubt tiefere Prozesstemperaturen bis auf typischerweise 700°C. Diesbezüglich sei nebst auf (1) auch auf (3) und (6) verwiesen.

Bezüglich LPCVD und unter Verweis auf (6) wird bei einer Abscheidetemperatur von 650°C eine Wachstumsrate (growth rate) von

$$GR = 50 \text{ Å/min}$$

angegeben. Dies bei einem Reaktivgasfluss für Silan von

$$F = 14 \text{ sccm.}$$

Daraus ergibt sich eine für die Gasausbeutung relevante Kennzahl, nämlich die Wachstumsrate pro Reaktivgasfluss-Einheit, $GR_F$ zu

$$GR_F = 3,6 \text{ Å/(sccm min)}$$

Auf 5"-Wafern, entsprechend einer Fläche

$$A_5 = 123 \text{ cm}^2,$$

umgerechnet von der aktuellen Fläche $A_2$ für 2"-Wafer ergibt sich eine Abscheidemenge (growth amount) GA zu

$$GA = 5,2 \cdot 10^{16} \text{ Si-Atome/sec.}$$

Wiederum bezogen auf eine Reaktivgasfluss-Einheit ergibt sich die Kennzahl "Abscheidemenge pro Reaktivgasfluss-Einheit", im weiteren "Gasausnützungszahl" genannt, $GA_F$ zu

$$GA_F = 8,4 \cdot 10^{-3},$$

entsprechend 8,4 0/00.

Bei 650°C entsteht eine epitaktische Schicht.

Wird die Abscheidetemperatur auf 600°C reduziert, so entsteht eine polykristalline Schicht. Dies mit:

GR = 3 Å/min

F = 28 sccm Silan

$GR_p = 0,11$ Å/(sccm/min)

GA = 3,1 · 10$^{15}$ Si-Atome/sec auf $A_5$

$GA_F = 2,5 \cdot 10^{-4}$, entsprechend 0,25 0/00.

Grundsätzlich sind folgende Kriterien für ein defektfreies epitaktisches Schichtwachstum erforderlich:

- Bei Transmissionselektronen-Mikroskopie an Querschnittspräparaten wird der Nachweis der Epitaxie durch Elektronendiffraktion und Hochauflösung erstellt.

- In dabei typischerweise durchstrahlbaren Bereich von 10 - 15 μm längs der Grenzfläche zum Substrat, dürfen keine Defekte sichtbar sein. Typische Vergrösserungen bei der Defektanalyse sind 110'000 bis 220'000.

Eine weitere Entwicklung ist die Ultrahochvakuum-chemische Gasphasenabscheidung (UHV-CVD) mit Arbeitsdrücken im Bereich von $10^{-4}$ bis $10^{-2}$ mbar, typischerweise im Bereich von $10^{-3}$ mbar, wozu verwiesen sei auf (4) sowie auf (5), (7). Sie lässt sehr niedrige Werkstücktemperaturen zu, wobei allerdings die Wachstums- bzw. Beschichtungsraten extrem klein sind, so z.B. ca. 3 Å/min für reines Silizium bei 550°C gemäss (5).

Der Grund für die kleinen Wachtumsraten liegt darin, dass die Absorptions- und Zerfallsrate der reaktiven Moleküle, so z.B. von $SiH_4$, mit zunehmender Wasserstoffbelegung der WerkstückOberfläche abnimmt. Das Schichtwachstum wird also durch die Desorptionrate von $H_2$ limitiert, die aber exponentiell mit der Temperatur zunimmt. Hierzu sei auf (8) verwiesen. Wegen der kleineren Bindungsenergie der Ge-H-Bindung im Vergleich zur Si-H-Bindung ist die Wasserstoffdesorption von einer Si-Ge-Legierungsoberfläche grösser, so dass bei gleicher Substrattemperatur eine höhere Wachstumsrate als bei reinem Si resultiert, z.B. bei einem Gehalt von 10% Ge um einen Faktor 25 bei 550°C (5).

Eine weitere Möglichkeit, bei niedrigen Substrattemperaturen hohe Abscheideraten mit Epitaxie-Qualität zu erzielen, besteht darin, (9), die reaktiven Gase mit Hilfe eines μ-Wellen-Plasmas zu zersetzen (ECRCVD).

Durch den Einsatz von Plasmaquellen, die auf dem Prinzip der Elektronen-Zyklotron-Resonanz beruhen, soll der Einfall hochenergetischer Ionen auf das Substrat vermieden werden.

Solche Quellen arbeiten in der Regel im Druckbereich von $10^{-3}$ bis $10^{-4}$ mbar, was aber zu grösseren freien Weglängen führt, als im Fall von kapazitiv eingekoppelten Hochfrequenz-Hf-Plasmen. Dies kann wiederum zu unerwünschtem Ionenbeschuss des Substrates führen und damit zur Erzeugung von Defekten, wie sich aus (10) ergibt. Die Energie der auf das Substrat auftreffenden Ionen kann aber durch eine externe Kontrolle des Substratpotentials begrenzt werden, wodurch sich Ionenschäden weitgehend vermeiden lassen. Auch mit ECRCVD-Methode betragen die Wachstumsraten für reines Silizium in der Regel nur einige 10 Å/min, bei tiefen Abscheidetemperaturen $\leq$ 600°C.

Zusammengefasst ergibt sich folgendes:

Epitaktische Schichten können bei Abscheidetemperaturen $\leq$ 600°C, bis heute:

- durch UHV-CVD mit Wachstumsraten GR von ca. 3 Å/min oder

- durch ECRCVD mit einer um ca. 1 Grössenordnung (30 Å/min) höheren Wachstumsrate GR

abgelegt werden.

PECVD-Verfahren, deren Plasma durch DC-Entladungen erzeugt werden, konnten für die Fertigung epitaktischer Schichten - d.h. entsprechend geringer Fehlerdichte (siehe oben) - mindestens nicht mit einer für industrielle Fertigung sicherzustellenden Wachstumsrate GR, Zuverlässigkeit und Effektivität bzw. Wirkungsgrad und Abscheidetemperaturen = 600°C eingesetzt werden.

über die Verwendung von kapazitiv eingekoppelten Hochfrequenzfeldern zur Erzeugung von Hf-Plasmen für PECVD-Verfahren wurde anderseits schon sehr früh berichtet, wozu verwiesen sei auf (11). Die Schwierigkeit bei diesem Vorgehen liegt darin, dass in solchen Hf-Plasmen nicht nur die reaktiven Gase zersetzt werden. Gleichzeitig ist die Substratoberfläche einem intensiven Beschuss hochenergetischer Ionen ausgesetzt, wie dies spezifisch auch bei reaktivem Zerstäuben oder Hochfrequenzätzen ausgenützt wird. Dies begünstigt einerseits die Wasserstoff-Desorption, führt aber gleichzeitig zu Defekten in den wachsenden Schichten. Eine davon abgewandelte Methode, die RPCVD, Remote Plasma Chemical Vapour Deposition, berücksichtigt dies dadurch, dass die zu beschichtenden Substrate nicht direkt dem Hf-Plasma ausgesetzt werden, was zu besseren Resultaten führt (12). Allerdings sind die erzielten Wachstumsraten gering, nämlich meist Bruchteile von nm pro Minute bis höchstens einige nm pro Minute gemäss (13).

In S.R. Shanfield "Plasma-Enhanced Chemical Vapor Deposition of Epitaxial Silicon from Silane" Extended Abstracts, vol. 83-1(1983), pages 230-231, XP-002056339 wird vorgeschlagen auf gereinigte (100) - oder (111) - orientierte Silizium-Wafer eine Silizium Epitaxie-Schicht abzulegen. Dabei wird ein PECVD-Verfahren eingesetzt. Es wird eine DC-Niederspannungsentladung eingesetzt mit einer typischen Entladespannung von 25 V und einem Entladestrom von typisch 1 A. Bei den tiefsten mit PECVD sich ergebenden Werkstücktemperaturen von 750°C ergeben sich Wachstumsraten von circa 25 nm/min.

Aus K.P. Pande "Low Temperature Plasma-Enhanced Epitaxy of GaAS", Journal of the Electrochemical Society, vol. 131, no. 6, June 1984, pages 1357-1359, XP002056343 ist es weiter bekannt, GaAs Epitaxie-Schichten abzulegen durch ein so genanntes PE-MO-CVD Verfahren, bei welchem das zu beschichtende Substrat nicht direkt einem Plasma ausgesetzt wird. Das zu beschichtende Substrat wird auf einer ersten Elektrode abgelegt und eine zweite Elektrode wird darunter angeordnet. Bezüglich der passiven zweiten Elektrode wird das Substrat und die Halterung auf 300-350 V gelegt, derart, dass sich unterhalb der Halterung ein Plasma ausbildet. Bei Temperaturen im Bereich von 400°C werden Wachstumsraten von circa 80 nm/min erreicht.

Aufgabe der vorliegenden Erfindung ist es, für industrielle Fertigung geeignete Verfahren anzugeben, die erlauben, epitaktische Schichten aufzuwachsen mit hoher Wachstumsrate und bei tiefer Abscheidetemperatur.

Dies wird durch das Verfahren nach Anspruch 1 bzw. nach Anspruch 2 erreicht. Bevorzugte Ausführungsformen der Verfahren sind in den Ansprüchen 2 bis 43 spezifiziert. Das erfindungsgemässe Verfahren eignet sich insbesondere für die Verwendung zur Herstellung von Solarzellen, FET's oder Bipolar-Transistoren.

Dabei können insbesondere auch dotierte Halbleiterschichten abgelegt werden. Silizium und/oder Germanium enthaltende Schichten, dotiert vorzugsweise mit mindestens einem Element aus den Gruppen III oder V des Periodensystems bzw. Gallium enthaltende Schichten mit mindestens einem Element der Gruppen II, III, IV oder VI des Periodensystems, z.B. mit Mg oder Si.

Aus den eingangs abgehandelten Beschichtungstechniken zur Erzeugung epitaktischer Schichten kann zusammenfassend folgendes ausgeführt werden:

- Die CVD-Verfahren, insbesondere die UHV-CVD-Verfahren führen zu ausgezeichneten Schichtqualitäten, selbst bei Substrattemperaturen unterhalb von 500°C. Sie bieten sich deshalb an, auch epitaktische Schichten herzustellen, wo an die Schichtqualität extrem hohe Anforderungen gestellt werden. Die Wachstumsrate beispielsweise für Si ist aber bei diesen Verfahren extrem tief, wie erwähnt in der Grössenordnung von 3 Å/min bei 550°C.

- Mikrowellen-Plasma-unterstützte Verfahren, ECRCVD, haben den Vorteil, dass die Zersetzung der reaktiven Moleküle ohne hohe thermische Energie stattfinden kann. Der Ionenbeschuss des Substrates führt zu erhöhter Wasserstoffdesorption. Beide Effekte könnten zu einer beträchtlichen Zunahme der Wachstumsrate führen. Bei tiefen Temperaturen werden aber inakzeptabel hohe Defekt-Dichten beobachtet, induziert durch Ionenbeschuss. Eine Kontrolle über die Substrat-Bias-Spannung erhöht zwar die Schichtqualität, ändert aber nichts an den vergleichsweise kleinen Raten.

Damit scheint ein inhärenter Widerspruch zu bestehen: Ionenbeschuss des Substrates führt einerseits zu erhöhter Wachstumsrate aufgrund erhöhter Wasserstoffdesorption, führt aber gleichzeitig zur Erhöhung der Defekt-Dichte.

Für unter Atmosphärendruck betriebene, thermische CVD-Verfahren ergibt sich laut (2) folgendes Bild:

- Si-Wachstumsrate GR: $2 \times 10^{-3}$ nm/min
  (bei 600°C, $3 \cdot 10^{-2}$ nm/min gemessen und auf 550°C umgerechnet)

- Gasfluss, $SiCl_2H_2$, F: 100 sccm.

Daraus ergibt sich eine Wachstumsrate GR pro $SiCl_2H_2$-Fluss-Einheit, $GR_F \approx 2 \times 10^{-4}$ Å/(sccm.min).

Ein Gasfluss F von 100 sccm $SiCl_2H_2$ entspricht $4,4 \times 10^{19}$ Molekülen/sec.

Die Wachstumsrate GR von $2 \times 10^{-3}$ nm/min entspricht einer Wachstumsrate von $2 \times 10^{-4}$ Silizium-Monolagen pro Sekunde auf einem 5"-Wafer, entsprechend einer Fläche $A_s$ von 123 cm$^2$. Damit ergibt sich auf der Gesamtfläche pro Sekunde eine abgelegte Menge von

$$GA = 1,7 \times 10^{13} \text{ Siliziumatome/sec.}$$

Durch Inbeziehungsetzen der pro Sekunde abgelegten Siliziummenge und der pro Sekunde eingelassenen Reaktivgasmenge ergibt sich die Gasausnützungsziffer $GA_F$ zu

$$GA_F = 3,9 \times 10^{-7}.$$

Dies entspricht einer Ausnützung von ungefähr 0,0004 0/00.

Wir halten fest, dass sich bei atmosphärischem CVD ergibt:

$$GR_F \approx 2 \times 10^{-4} \text{ Å/(sccm.min)}$$

$$GA_F \approx 0,0004 \text{ 0/00.}$$

Aus (5), kombiniert mit (4) und (7), ergibt sich die Abschätzung für UHV-CVD zu

$$GR_F \approx 0,1 \text{ Å/(sccm.min)}$$

und

$$GA_F \approx 0,0035 \text{ entsprechend ca. 35 0/00.}$$

Dies zu den bis anhin industriell eingesetzten Verfahren für die Herstellung von Schichten in Epitaxie-Qualität.

Aus der DE-OS 36 14 384 ist nun weiter ein PECVD-Verfahren bekannt, bei welchem DC-Glimmentladung in Form einer Niederspannungs-Entladung eingesetzt wird. Damit sollen Schichten mit besonders guten mechanischen Eigenschaften schnell, d.h. mit hoher Wachstumsrate, abgelegt werden.

Eine Kathodenkammer mit Heisskathode kommuniziert mit einem Vakuumrezipienten über eine Blende. Der Blende gegenüberliegend ist eine Anode vorgesehen. Parallel zu der zwischen Blende und Anode gebildeten Entladungsachse ist eine Einlassanordnung für ein Reaktivgas vorgesehen, dieser Anordnung, bezüglich der Entladungsachse gegenüberliegend, sind die Werkstücke angeordnet. Mit Bezug auf Anodenpotential, werden Entladungsspannungen $U_{AK}$ unterhalb 150 V angelegt, und die Entladung wird mit einer Stromstärke $I_{AK}$ von wenigstens 30 A betrieben. Für die Beschichtung werden die Werkstücke auf negative Potentiale zwischen 48 und 610 V gebracht.

Die darin gezeigten Versuche ergeben folgendes Bild:

| Beispiel | GR[Å/min] | $GR_F$[Å/ (sccm. min) ] |
|---|---|---|
| 1 | $10^3$ | 2,5 |
| 2 | 380 | 1,2 |

(fortgesetzt)

| Beispiel | GR[Å/min] | GR$_F$[Å/ (sccm. min) ] |
|---|---|---|
| 3 | $2 \times 10^3$ | 2,5 |
| 4 (Si) | 166 | 0,7 |
| 5 | 466 | 1,2 |
| 6 | 750 | 0,7 |
| 7 | 250 | 0,5 |
| 8 | 500 | 0,75 |
| 9 | 316 | 0,38 |
| 10 | 344 | 0,18 |
| 11 | 62 | 0,18 |
| 12 | 58 | 0,14 |

Die vorliegende Erfindung geht nun davon aus, dass Werkstücke mit Epitaxie-Schichten beschichtet werden können, indem ein PECVD-Verfahren mit DC-Entladung - und im speziellen ein PECVD-Verfahren, wie es, von seinem Prinzip her, aus der DE-OS 36 14 348 bekannt ist - eingesetzt wird. Es wurden

a) Wachstumsraten GR von mindestens 300 Å/min, gar von mindestens 600 Å/min

b) GR$_F$ von mindestens 7,5 Å/(sccm.min), oder gar 40 Å/(sccm.min), vorzugsweise gar 75 Å/(sccm.min)

c) Gasausnützungsziffern GA$_F$ mindestens im Bereich von 5%.

d) Werkstücktemperaturen = 600°C bzw. = 800°C realisiert.

Es wird erkannt, dass am erfindungsgemäss eingesetzten DC-PECVD-Verfahren die Plasmaentladung zu tiefstenergetischen Ionen führt, ebenso zu tiefstenergetischen Elektronen, dass aber die Ladungsträgerdichte, insbesondere die Elektronendichte an der ausgenützten Entladung sehr gross ist.
Die Erfindung wird anschliessend anhand von Figuren beispielsweise erläutert. Es zeigen:

Fig. 1: schematisch eine erste bevorzugte Ausführungsform einer Anlage zur Durchführung der erfindungsgemässen Verfahren,

Fig. 2: schematisch eine zweite bevorzugte Ausführungsform einer Anlage gemäss Fig. 1 mit mehreren Betriebsvarianten,

Fig. 3: bei Betrieb einer Anlage gemäss Fig. 2 für eine Siliziumbeschichtung, die Abhängigkeit der Wachstumsrate von der Wafer-Temperatur,

Fig. 4: in Funktion des Entladungsstromes, die Zunahme der Wachstumsrate bezogen auf den Reaktivgasfluss, GR$_F$,

Fig. 5: in Funktion des Reaktivgasflusses, die Wachstumsrate bei unterschiedlichen Plasmadichten im Bereich der Werkstücke,

Fig. 6: in Funktion der Germanium-Konzentration an der abgeschiedenen Schicht, die Wachstumsrate und

Fig. 7: Im Feld Wachstumsrate/Gasausnützungsziffer die Resultate gemäss Stand der Technik und gemäss Erfindung.

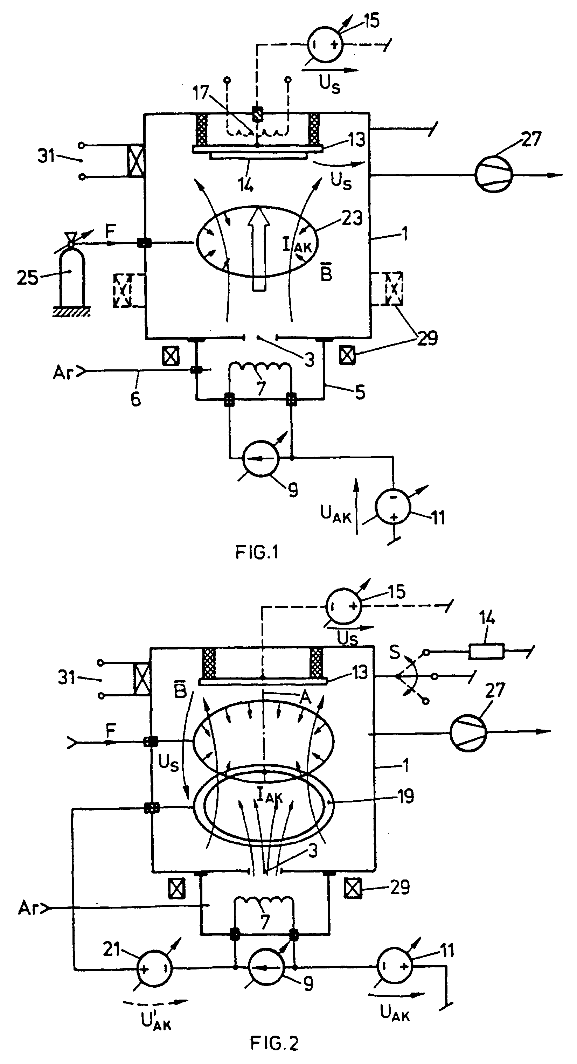

Vorab, eine Anlage gemäss z.B. der DE-OS 36 14 384 kann durchaus für die Durchführung der erfindungsgemässen Verfahren eingesetzt werden, sofern sie so betrieben wird, dass die erfindungsgemässen Verfahren eingehalten werden.
Gemäss Fig. 1 weist eine heute bevorzugte erste Anlage zur Durchführung der erfindungsgemässen Verfahren einen Vakuumrezipienten 1 auf, an welchen, über eine Blende 3, eine Kathodenkammer 5 angeflanscht ist. In bekannter Art und Weise kann die Kathodenkammer 5 auf das elektrische Potential des Rezipienten 1 gelegt sein, oder die Kathodenkammer 5 kann bezüglich des Rezipienten 1 isoliert und auf davon abweichendes Potential gelegt sein (nicht dargestellt).

In der Kathodenkammer 5 ist eine Heisskathode 7, ein Filament, vorgesehen, vorzugsweise direkt beheizt mittels eines Heizstromgenerators 9.

In der Blenden-Achse A, der Blende 3 im Rezipienten 1 gegenüberliegend, ist ein isoliert montierter Werkstückträger 13 vorgesehen. Im Bereich des Werkstückträgers 13 kann eine Werkstückheizung 17 vorgesehen sein. Der Rezipient 1 wird mit einer Vakuumpumpe 27, vorzugsweise einer Turbovakuumpumpe, dabei vorzugsweise einer Turbomolekularpumpe evakuiert. Sensoren, wie z.B. ein Plasmamonitor etc., können, zu Beobachtungs- und ggf. Steuerzwecken, an einem Anschluss 31 vorgesehen werden.

Konzentrisch zur Achse A der Entladung mit dem Entladungs-Strom $I_{AK}$ ist ein Gaseindüsring 23 vorgesehen als Reaktivgaseindüsanordnung, verbunden mit einer Gastankanordnung 25 für Reaktivgas, welches, mit steuerbarem Fluss F (sccm), in den Rezipienten eingelassen wird.

In die Kathodenkammer 5 mündet ein Anschluss 6 zu einem Arbeitsgastank, beispielsweise mit Ar. Mittels einer Elektround/oder Permanent-Magnetanordnung 29 wird im wesentlich konzentrisch zur Achse A im Rezipienten, ein Magnetfeld B erzeugt, insbesondere auch wirksam im Bereich der Blende 3. Das Feld kann dabei vorzugsweise aus der Konzentrizität verschoben werden.

Die Anlage in ihrer Ausführungsform gemäss Fig. 1 wird wie folgt betrieben:

- Die Rezipientenwand entsprechend 1 wird als Anode der Entladung eingesetzt und ist hierzu auf ein Bezugspotential, wie dargestellt vorzugsweise auf Masse, geschaltet. Entsprechend ist mittels eines vorzugsweise einstellbaren DC-Generators 11 die Kathode 7 auf (negatives) Potential gelegt. Über dem Generator 11 liegt die Entladespannung $U_{AK}$, der Entladestrom $I_{AK}$ fliesst zwischen Kathode 7 und Rezipienten 1.

- In einer zweiten Betriebsvariante der in Fig. 1 dargestellten Anlage wird der Werkstückträger 13 mittels eines DC-Bias-Generators 15 auf die Spannung $U_s$ gelegt.

In Fig. 2 ist eine weitere bevorzugte, Anlage zur Durchführung der erfindungsgemässen Verfahren dargestellt. Es sind für gleiche Teile dieselben Bezugszeichen wie in Fig. 1 verwendet. Die Anlage nach Fig. 2 unterscheidet sich wie folgt von der in Fig. 1 dargestellten und beschriebenen:

Es ist eine ringförmige Hilfsanode 19 vorgesehen, welche konzentrisch zur Entladungsachse A angeordnet ist.

Folgende Betriebsarten sind hier möglich:

- Wie mit dem Variationsschalter S schematisch dargestellt, wird die Rezipientenwandung des Rezipienten 1, wie bereits in Fig. 1, auf Bezugs- vorzugsweise Massepotential gelegt oder, über ein Impedanzelement 14, vorzugsweise ein Widerstandselement, an ein Potential, vorzugsweise das Bezugspotential, gefesselt oder aber potentialschwebend betrieben. Die Hilfsanode 19 wird dann, wenn der Rezipient 1 auf Bezugspotential gelegt ist entweder auf das Potential des Rezipienten gelegt oder mittels eines vorzugsweise einstellbaren DC-Generators 21 an Spannung gelegt.

- Wenn der Rezipient 1 über Impedanzelement 14 an ein Bezugspotential gefesselt wird, dann wird die Hilfsanode mittels des DC-Generators 21 betrieben, es erscheint die Entladespannung $U_{AK}$ wie gestrichelt dargestellt zwischen Kathode 7 und Hilfsanode 19. Dies ist auch dann der Fall, wenn die Rezipientenwandung 1 potential-schwebend betrieben wird.

Heute wird der Betrieb der Anlage nach Fig. 2 mit auf Masse gelegter Rezipientenwand und Hilfselektrode 19 sowie potential-kontrolliert betriebenem Werkstückträger 13 bevorzugt. In allen Anlagen-Varianten sind folgende Einstellungen wesentlich:

- Totaldruck $P_I$ im Rezipienten:

$$10^{-4} \text{ mbar} \leq P_T \leq 10^{-1} \text{ mbar}$$

vorzugsweise

$$10^{-3} \text{ mbar} \leq P_T \leq 10^{-2} \text{ mbar}$$

typischerweise im Bereich von $5 \cdot 10^{-3}$ mbar. Dieser Druck wird vornehmlich sichergestellt durch den Partialdruck des Arbeitsgases, vorzugsweise Argon. Die Vakuumpumpe 27 ist deshalb, wie erwähnt, vorzugsweise als Turbovakuumpumpe ausgebildet, insbesondere als Turbomolekularpumpe.

- Arbeitsgasdruck $P_A$ :

    Dieser wird wie folgt gewählt:

$$10^{-4} \text{ mbar} \leq P_A \leq 10^{-1} \text{ mbar}$$

    vorzugsweise zu

$$10^{-3} \text{ mbar} \leq P_A \leq 10^{-2} \text{ mbar}$$

- Reaktivgaspartialdruck $P_R$:

    Dieser wird vorzugsweise wie folgt gewählt:

$$10^{-5} \text{ mbar} \leq P_R \leq 10^{-1} \text{ mbar}$$

    vorzugsweise zu

$$10^{-4} \text{ mbar} \leq P_R \leq 10^{-2} \text{ mbar}.$$

Insbesondere für Silizium- und/oder Germanium-haltige Gase werden Partialdrücke zwischen $10^{-4}$ mbar und $25 \cdot 10^{-3}$ mbar angeraten. Zur Unterstützung der Planarität (Oberflächenrauhigkeit), vor allem für Mehrfachschicht-Abscheidungen und Schichten mit Dotierung wird weiter angeraten, zusätzlich einen Wasserstoff-Partialdruck in der Grössenordnung von $10^{-4}$ bis $10^{-2}$ mbar, vorzugsweise von ca. $10^{-3}$ mbar vorzusehen.

- Gasströme:

    Argon: weitestgehend abhängig von Rezipienten- und Kathodenkammer-Volumen, zur Einstellung des erforderlichen Partialdruckes $P_A$ bzw. $P_T$.

    Reaktivgasfluss: 1 bis 100 sccm, insbesondere für Siliziumund/oder Germanium-haltige Gase:

    $H_2$: 1 bis 100 sccm.

- Entladespannung $U_{AK}$:

    Die Entladespannung, sei dies zwischen Kathode 7 und Rezipienten 1 gemäss Fig. 1 oder zwischen Kathode 7, Rezipienten 1 und Hilfsanode 19 bzw. zwischen Kathode 7 und Hilfsanode 19, wird wie folgt eingestellt:

$$10 \text{ V} \leq U_{AK} \leq 80 \text{ V},$$

    vorzugsweise

$$20 \text{ V} \leq U_{AK} \leq 35 \text{ V}.$$

- Entladeströme, $I_{AK}$:

  Diese werden wie folgt gewählt:

$$5\ A \leq I_{AK} \leq 400\ A,$$

  vorzugsweise

$$20\ A \leq I_{AK} \leq 100\ A.$$

- Werkstückspannung $U_s$:

  In jedem Fall wird diese Spannung unterhalb der Sputterschwelle der Entladung gewählt. Sie wird in allen Fällen wie folgt eingestellt:

$$-25\ V \leq U_s \leq +25\ V,$$

  vorzugsweise für Ga-Verbindungen, vorzugsweise für Si, Ge und deren Verbindungen

$$-20\ V \leq U_s \leq +20\ V,$$

  vorzugsweise negativ, und dabei vorzugsweise zu

$$-15\ V \leq U_s \leq -3\ V.$$

- Stromdichte am Ort der zu beschichtenden Werkstückoberfläche:

  Diese wird vorab mittels einer Sonde am Ort, wo nachmals die zu beschichtende Oberfläche positioniert wird, gemessen. Sie wird eingestellt bezogen auf die Sondenoberfläche zu mindestens 0,05 A/cm$^2$, vorzugsweise zu mindestens 0,1 A/cm$^2$ bis maximal Entladungsstrom/Substratfläche.

  Diese Stromdichte wird wie folgt gemessen und eingestellt:

  Eine oder mehrere Sonden werden am Ort der nachmals zu beschichtenden Fläche positioniert und bezüglich Masse bzw. Anodenpotential auf variable positive Spannung gelegt. Diese wird solange erhöht, bis der gemessene Strom nicht mehr weiter ansteigt. Der gemessene Stromwert ergibt, bezogen auf die Sondenfläche, die gesamte Stromdichte. Diese wird nun durch Einstellung der Entladung auf den geforderten Wert gestellt. Die Einstellung der erwähnten Stromdichtewerte ist mit den bevorzugt eingestellten Entladeströmen $I_{AK}$ zwischen 5 und 400 A, bzw. und bevorzugt zwischen 20 und 100 A ohne weiteres möglich.

  Der hohe Fluss niederenergetischer Ionen und Elektronen, die auf das Werkstück auftreten, ist ein charakteristisches Merkmal des erfindungsgemässen Verfahrens, welches mithin als LEPECVD abgekürzt wird für "Low Energy Plasma Enhanced CVD".

Silizium- und/oder Germaniumschichten können während der Beschichtung durch Zugabe eines Dotierungsgases mit einem Element aus der Gruppe III oder V des periodischen Systems, wie mit Phosphin, Diboran, Arsin etc. zu n- oder p-leitenden Schichten dotiert werden. Somit sind p/n-Halbleiterübergänge in situ herstellbar, z.B. besonders wirtschaftlich für die Solarzellenherstellung.

Werden Galliumschichten oder Galliumverbindungs-Schichten abgelegt, so können diese durch Verwendung eines Dotierungsgases mit einem Element aus den Gruppen II oder III oder IV oder VI des Periodensystems dotiert werden, z.B. mit Mg oder Si.

Mit Hilfe der Anode 19 und/oder des Magnetfeldes B kann die Niederspannungsentladung komprimiert und/oder vom Werkstückträger 13 abgelenkt werden. Damit kann die Plasmadichte am Werkstückträger erhöht (Rate) und/oder über einen grossen Bereich variiert (Einstellung der Verteilung) oder auch gesteuert gewobbelt bzw. abgelenkt werden. Mit Hilfe der Heizung 17 können die Werkstücke bzw. Substrate unabhängig vom Ionen- und/oder Elektronenanfall bis auf ca. 800°C aufgeheizt werden. Die Magnetanordnung 29 erzeugt mittels Permanent- und/oder Elektromagneten das Feld B, vorzugsweise mit einer Flussdichte von einigen 10 bis einigen 100 Gauss im Entladungsraum.

Aufgrund der unüblich tiefen Entladespannungen, wie erwähnt bevorzugt im Bereich von 20 bis 35 V, ergibt sich ein Plasmapotential der Entladung entsprechend (15) nahe am Anodenpotential. Das Werkstück- bzw. Substratpotential kann potentialmässig leicht so verstellt werden, dass die Ionenenergien unterhalb 15 eV liegen, womit sich Ionenschäden während des Schichtwachstums am Werkstück vollständig vermeiden lassen.

Wie erwähnt wurde, ist eine möglichst hohe Plasmadichte am Werkstück anzustreben. Vorliegendenfalls wird die Plasmadichte durch die Stromdichte an der Werkstückoberfläche gegeben. Sie wird wie vorgängig angegeben mittels Sonden in einem Kalibrier-Arbeitsgang gemessen und eingestellt.

Die Anlagen, wie sie schematisch in den Fig. 1 und 2 dargestellt sind, sind wohl heute bevorzugte Ausführungsformen, wobei die erfindungsgemässen Verfahren sich durchaus auch an Anlagen realisieren lassen, die beispielsweise in der DE-OS 36 14 384 dargestellt sind, wenn sie entsprechend bestückt und geführt werden. Wesentlich erscheint bis heute der potentialkontrollierte Betrieb des Werkstückes.

Mittels einer Anlage, wie sie in Fig. 2 schematisch dargestellt ist, wurden 3"-Silizium-Einkristallsubstrate mit Silizium bzw. einer Silizium/Germanium-Legierung epitaktisch beschichtet. Das Volumen des Rezipienten 1 betrug 60 1.

Die Anlage wurde wie folgt betrieben:

Hilfsanode 19 auf Potential des Rezipienten 1; Werkstückträger 13 auf kontrolliertes Biaspotential. Rezipient als Anode auf Masse.

Folgende Arbeitspunkteinstellungen wurden vorgenommen:

• Werkstücktemperaturen $T_s$

Plasmainduziert ergeben sich Werkstücktemperaturen von nur wenigen 100°C, so z.B. von ca. 150°C.

Dies ist ausserordentlich vorteilhaft zum Beschichten thermisch kritischer Substrate, wie z.B. organischer Substrate.

Höhere, erwünschte Temperaturen werden durch separates Heizen erreicht. Für die Herstellung von Si- und/oder Ge-Schichten und Schichten mit Ge-Si-Verbindungen werden Werkstücktemperaturen $T_s$

$$300°C \leq T_s \leq 600°C$$

angeraten, für Ga-Schichten oder Ga-Verbindungsschichten:

$$300°C \leq T_s \leq 800°C.$$

Weil das Verfahren "kalt" ist, ist man höchst flexibel in der Temperatur-Wahl, je nach Schichtmaterial und Substratmaterial.

|      | Fluss [sccm] | Partialdruck [mbar] |
|------|--------------|---------------------|
| Ar   | 50           | $6, 8 \times 10^{-3}$ |
| $H_2$ | 5           | $7 \times 10^{-3}$  |
| $SiH_4$ | 10        | $10^{-3}$           |

| Entladestrom $I_{AK}$ | 70 A. |
|------------------------|-------|
| Entladespannungen $U_{AK}$ | 25 V. |
| Substrat-Temperatur | 550°C (mit Heizung geheizt) |

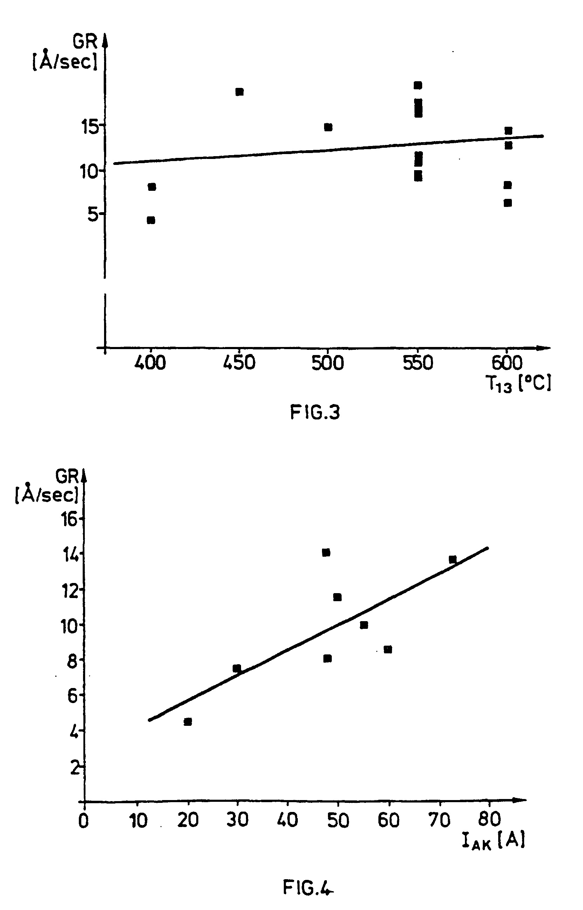

In einem ersten Versuch wurde mit Hilfe der Heizung 17 die Substrattemperatur variiert. Dabei wurden die übrigen Arbeitspunkt-Parameter konstant gelassen. In Fig. 3 ist das Resultat dargestellt. Aus dieser Figur ist ersichtlich, dass die Wachstumsrate GR nur sehr wenig von der Werkstück- bzw. Substrattemperatur $T_{13}$ abhängt. Die grosse Streuung der Messwerte rührt davon her, dass bei der Versuchsanlage vor jeder Abscheidung Betriebsparameter jeweils von Hand wieder eingestellt werden mussten.

Ausgehend von den erwähnten Arbeitspunktwerten wurde nun der Entladestrom $I_{AK}$ variiert, durch Einstellung der Entladespannung $U_{AK}$ und gegebenenfalls Variation des Kathoden-Heizstromes. Alle übrigen Parameter wurden wieder konstant gehalten. Wenn auch der Entladestrom $I_{AK}$ nicht direkt der Ladungsträgerdichte bzw. Plasmadichte an der zu beschichtenden Oberfläche entspricht, so ist doch, bei sonst konstant belassenen Parametern, die Plasmadichte, entsprechend der Stromdichte an der zu beschichtenden Werkstückoberfläche, im wesentlichen proportional zum Entladestrom. Deshalb zeigt das in Fig. 4 dargestellte Resultat durchaus die Proportionalität und den Proportionalitätsfaktor zwischen der Wachstumsrate GR und der Plasmadichte. Diese Proportionalität dürfte anhalten, solange die Gasausnützung nicht ca. 60 % übersteigt und Sättigungseffekte auftreten. Wie erwähnt kann die Plasmadichte nebst z.B. durch Verstellung des Entladestromes auch durch Fokussierung bzw. Defokussierung der Niederspannungsentladung bzw. durch deren Umlenken beeinflusst werden. Auch hier erklärt sich die relative grosse Streuung durch das Vorgehen bei der Einstellung der Entladebedingungen.

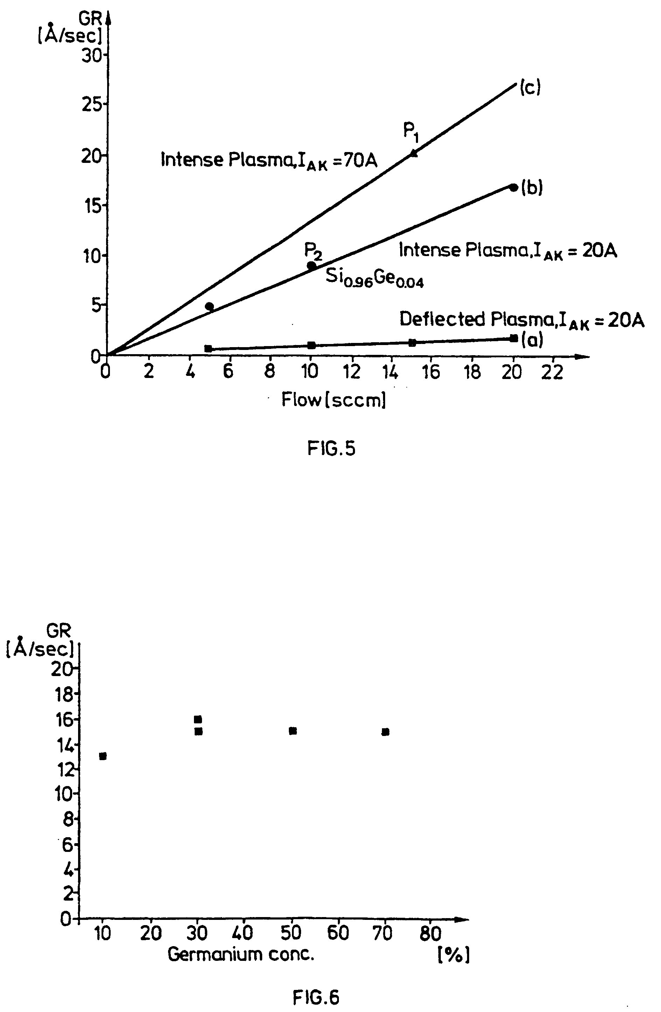

Höchst aufschlussreich ist schliesslich Fig. 5. Diese ist das Ergebnis von Versuchen, bei welchen, bei sonst konstant gehaltenen Parametern; der Reaktivgasfluss F variiert wurde, ausgehend vom Arbeitspunkt 10 sccm. Die Gerade (a) ergab sich bei bezüglich der Achse A von Fig. 1 durch Magnetfeldeinstellung örtlich leicht versetzter Niederspannungsentladung, was am Substrat zu einer Plasmadichtereduktion führte bzw. geringerer Rate, bei einem Entladestrom $I_{Ak}$ von 20 A.

Kurve (b) zeigt die Rate bei nicht abgelenkter Entladung und bei $I_{AK}$ = 20 A. Schliesslich zeigt (c) die erhöhte Rate bei nicht abgelenkter Enladung mit $I_{AK}$ = 70 A.

Bei einem Reaktivgasfluss von 10 sccm ergibt sich bei einer Temperatur des Substrates von 550°C und 70 A Entladestrom $I_{AK}$, wie Fig. 3 bestätigt, eine GR von ca. 15 Å/sec.

Bei einem Entladestrom von 70 A bei einem Reaktivgasfluss von 10 sccm wird dieses Resultat auch durch Fig. 4 bestätigt. Die GR fällt bei einem Entladestrom von 20 A auf ca. 6 Å/sec ab.

Es seien nun die erfindungsgemässen Resultate mit den Resultaten vorbekannter Techniken verglichen.

a) Vergleich mit APCVD (2)

Aus Fig. 5 ergibt sich beispielsweise für den Punkt P1:

$$GR \approx 1200 \text{ Å/min,}$$

verglichen mit

$$GR \approx 2 \times 10^{-2} \text{ Å/min}$$

bei APCVD.

Aus Fig. 5 ergibt sich für den Punkt P1 ein Wert

$$GR_F \text{ von } 80 \text{ Å/(sccm.min)}$$

Der entsprechende Werte bei APCVD beträgt

$$GR_F \approx 2 \times 10^{-4} \text{ Å/(sccm.min)}$$

Berechnet man bei LEPECVD gemäss Erfindung die Gasausnützungsziffer für ein 3"-Substrat, so ergibt sich

$$GA_F \approx 6,8 \times 10^{-2},$$

entsprechend ca. 6,8 %.

Dabei ist zu berücksichtigen, dass diese Ziffer mit grösser werdenden Substratfläche, z.B. auf 5", noch wesentlich besser wird.

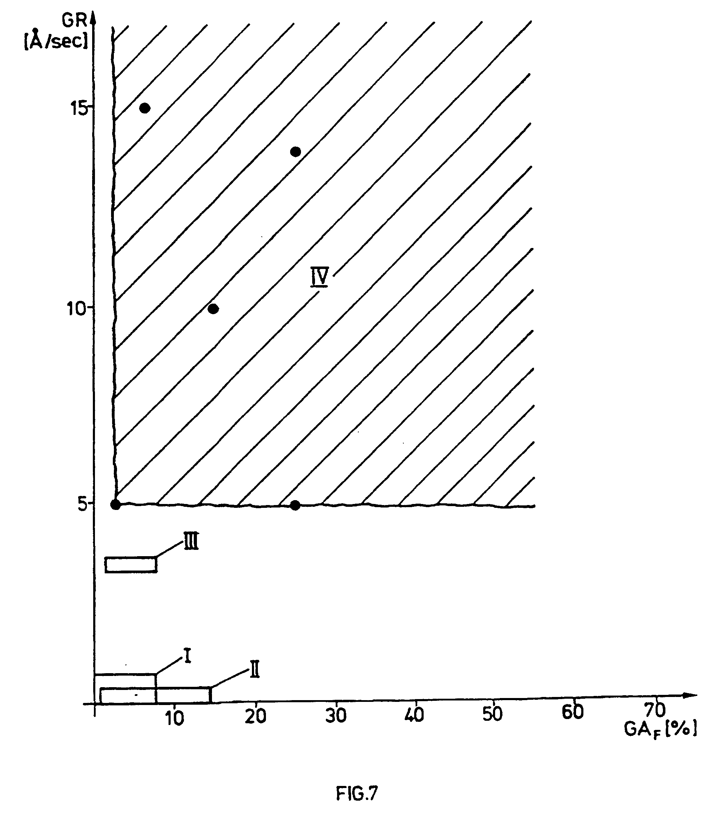

In Fig. 7 sind folgende Resultate dargestellt:

- Im Feld I: für APCVD, LPCVD, RPECVD;

- Im Feld II: für UHVCVD

- Im Feld III: für ECRCVD

- Im Feld IV: gemäss vorliegender Erfindung.

Sie gelten für Temperaturen $\leq 600°C$.

In diesem Zusammenhang muss nochmals betont werden, dass es das erfindungsgemässe Vorgehen erlaubt, relativ grosse Flächen zu beschichten, womit die Gasausnützungsziffer $GA_F$ zusätzlich steigt.

Werden, analog, die Grössen Wachstumsrate GR, Wachstumsrate pro Reaktivgasflusseinheit $GR_F$ und die Gasausnützungsziffer $GA_F$ mit den entsprechenden Zahlen für CVD unter atmosphärischen Druckbedingungen verglichen, so ergeben sich erfindungsgemäss in jeder Beziehung drastische Verbesserungen. Vergleicht man schliesslich die Resultate gemäss vorliegender Erfindung mit denjenigen, die erhalten werden, wenn ein PECVD-Verfahren mit Niederspannungsentladung gemäss der DE-OS 36 14 384 betrieben wird, so zeigt sich, dass erstaunlicherweise die erfindungsgemäss erzielte Wachstumsrate von 1200 Å/min wesentlich grösser ist, als die höchsten, mit dem vorbekannten Vorgehen erzielten Wachstumsraten und dass zusätzlich die erfindungsgemäss erzielte Wachstumsrate pro Reaktivgasflusseinheit $GR_F$ praktisch um zwei 10er-Potenzen höherliegt.

Es ist somit höchst erstaunlich, dass durch ganz bestimmte Betriebsbedingungen an der Anlage, prinzipiell wie sie aus der DE-OS 36 14 384 vorbekannt war, derartige Verbesserungen erzielbar sind, unter Berücksichtigung, dass die erfindungsgemäss abgelegten Schichten, bezüglich Defektdichte, Epitaxie-Bedingungen gehorchen.

Dies wurde höchst einfach dadurch überprüft, dass beim beschriebenen Betrieb der Anlage nach Fig. 2 mit den angegebenen Arbeitspunktparametern, bei Einlegen eines monokristallinen Substrates eine hochwertige Epitaxie-Beschichtung erzielt wurde, bei Einlegen eines amorphen Substrates hingegen, bei weiterhin festgehaltenen Arbeitspunktparametern, eine amorphe Beschichtung.

In Fig. 5 ist im weiteren bei P2 der Messpunkt eingetragen, wenn anstelle einer reinen Si-Schicht eine SiGe-Epitaxieschicht abgelegt wird, die 4 % Ge enthält.

Wie bereits daraus ersichtlich, ändern sich entgegen den vorerläuterten Erkenntnissen beim erfindungsgemässen Vorgehen die Verhältnisse nicht, wenn eine Ge/Si-Legierung abgelegt wird. Dies bestätigt Fig. 6, wo in Funktion des Ge-Gehaltes in % bei den angegebenen Arbeitspunkten die Wachstumsrate GR angegeben ist. Daraus ist ersichtlich, dass sich die Wachstumsrate in einem sehr grossen Bereich des Ge- zu Si-Verhältnisses im wesentlichen nicht ändert.

Das erfindungsgemässe Vorgehen wurde primär anhand von Versuchen, Si-, Ge- oder Si/Ge-Legierungsschichten bzw. Ga- und Ga-Verbindungsschichten, alle dotiert und nicht dotiert, abzulegen, erhärtet.

Mit dem erfindungsgemässen Vorgehen werden, kombiniert, höchste Schichtqualität bei sehr hohen Abscheidungsraten und gleichzeitig bei sehr hohem Wirkungsgrad, was abgelegtes Schichtmaterial pro eingelassener Reaktivgasmenge anbelangt, und bei tiefen Temperaturen $\leq 600°C$, erreicht. Damit eignet sich das vorgeschlagene Vorgehen ausserordentlich gut für die industrielle Fertigung, epitaxialer Schichten.

## Patentansprüche

1. Verfahren zur Herstellung von Werkstücken, die mit einer Silizium und/oder Germanium enthaltenden Schicht beschichtet sind, mittels PECVD in einem Totaldruck-Bereich von $10^{-4}$ mbar bis $10^{-1}$ mbar (beide Grenzwerte einschliesslich) und unter Einsatz einer DC-Niederspannungsentladung mit einer Entladespannung von höchstens 80 V, einem Entladestrom zwischen 5 A und 400 A (beide Werte eingeschlossen) sowie einer gemessenen minimalen Stromdichte von mindestens 0,05 A/cm$^2$ am Ort der abzulegenden epitaktischen Schicht, derart, dass eine Temperatur des Werkstückes von höchstens 600°C und eine Wachstumsrate von mindestens 30 nm/min eingehalten wird.

2. Verfahren zur Herstellung von Werkstücken, die mit einer Galium enthaltenden Schicht beschichtet sind, mittels PECVD in einem Totaldruck-Bereich von $10^{-4}$ mbar bis $10^{-1}$ mbar (beide Grenzwerte einschliesslich) und unter Einsatz einer DC-Niederspannungsentladung mit einer Entladespannung von höchstens 80 V, einem Entladestrom zwischen 5 A und 400 A (beide Werte eingeschlossen), sowie einer gemessenen minimalen Stromdichte von mindestens 0,05 A/ cm$^2$ am Ort der abzulegenden epitaktischen Schicht, derart, dass eine Temperatur des Werkstückes von höchstens 800°C und eine Wachstumsrate von mindestens 30 nm/min eingehalten wird.

**3.** Verfahren nach Anspruch 1 oder 2, **dadurch gekennzeichnet, dass** die Beschichtung mit einer Gasausnützungs-Ziffer

$$1 \% \leq GA_F \leq 90 \%$$

erfolgt.

**4.** Verfahren nach Anspruch 1, **dadurch gekennzeichnet, dass** die Wachstumsrate

$$GR \geq 600 \text{ Å/min,}$$

besonders bevorzugt

$$GR \geq 1'000 \text{ Å/min}$$

beträgt.

**5.** Verfahren nach Anspruch 4, **dadurch gekennzeichnet, dass** die Gasausnützungsziffer

$$GA_F \geq 5 \%$$

ist.

**6.** Verfahren nach einem der Ansprüche 1 bis 5, **dadurch gekennzeichnet, dass** die minimale Stromdichte mindestens 0,1 A/cm$^2$ bis zu einer Dichte von höchstens Entladestrom/Substratfläche beträgt.

**7.** Verfahren nach einem der Ansprüche 1 bis 6, **dadurch gekennzeichnet, dass** die gemessene Stromdichte überwiegend durch Elektronen-Einfall erzeugt wird.

**8.** Verfahren nach einem der Ansprüche 1 bis 7, **dadurch gekennzeichnet, dass** man den Entladestrom $I_{AK}$ zu

$$20 \text{ A} \leq I_{AK} \leq 100 \text{ A}$$

wählt.

**9.** Verfahren nach einem der Ansprüche 1 bis 8, **dadurch gekennzeichnet, dass** man die Entladungsspannung $U_{AK}$ zu

$$10 \text{ V} \leq U_{AK} \leq 80 \text{ V}$$

vorzugsweise zu

$$20 \text{ V} \leq U_{AK} \leq 35 \text{ V}$$

wählt.

**10.** Verfahren nach einem der Ansprüche 1 bis 9, **dadurch gekennzeichnet, dass** man den Reaktivgas-Partialdruck $P_R$ im Prozessraum zu

$$10^{-5} \text{ mbar} \leq P_R \leq 10^{-1} \text{ mbar}$$

wählt, vorzugsweise zu

$$10^{-4} \text{ mbar} \leq P_R \leq 10^{-2} \text{ mbar}.$$

**11.** Verfahren nach einem der Ansprüche 1 bis 10, **dadurch gekennzeichnet, dass** man im Prozessraum den Totaldruck $P_T$ wie folgt einstellt:

$$10^{-3} \text{ mbar} \leq P_T \leq 10^{-2} \text{ mbar}.$$

**12.** Verfahren nach einem der Ansprüche 1 bis 11, **dadurch gekennzeichnet, dass** man im Rezipienten einen Arbeitsgaspartialdruck $P_A$ wie folgt einstellt:

$$10^{-4} \text{ mbar} \leq P_A \leq 10^{-1} \text{ mbar},$$

vorzugsweise

$$10^{-3} \text{ mbar} \leq P_A \leq 10^{-2} \text{ mbar}.$$

**13.** Verfahren nach einem der Ansprüche 1 bis 12, **dadurch gekennzeichnet, dass** man die Entladespannung zwischen Entladungs-Kathode und auf ein Bezugspotential, vorzugsweise MassePotential, gelegte Vakuum Rezipientenwand anlegt.

**14.** Verfahren nach Anspruch 13, **dadurch gekennzeichnet, dass** man das Werkstück im Prozessraum

- auf Schwebepotential betreibt oder

- auf ein aufgeschaltetes Biaspotential legt.

**15.** Verfahren nach Anspruch 13, **dadurch gekennzeichnet, dass** man das Werkstück auf einer Spannung $U_s$ bezüglich Entladungsanode betreibt, die negativ ist, vorzugsweise $U_s \geq -25$ V beträgt, vorzugsweise zwischen -15 V bis -3 V beträgt.

**16.** Verfahren nach einem der Ansprüche 13 bis 15, **dadurch gekennzeichnet, dass** man entlang der Entladungs-Strecke eine Hilfsanode vorsieht, vorzugsweise in Form einer die Entladung umschlingenden Ringanode, und diese auf eine vorzugsweise einstellbare Spannung bezüglich Entladungskathode betreibt, die vorzugsweise nicht grösser ist als die Entladungs-Spannung.

**17.** Verfahren nach einem der Ansprüche 1 bis 12, **dadurch gekennzeichnet, dass** im Vakuum-Rezipienten eine diesbezüglich isoliert montierte Anode für die Entladung vorgesehen wird, vorzugsweise in Form einer Ringanode.

**18.** Verfahren nach Anspruch 17, **dadurch gekennzeichnet, dass** man das Werkstück im Prozessraum

- auf Schwebepotential oder

- auf ein aufgeschaltetes Biaspotential legt.

**19.** Verfahren nach Anspruch 18, **dadurch gekennzeichnet, dass** man das Werkstück bezüglich Entladungskathode höchstens auf Entladungsspannung betreibt.

**20.** Verfahren nach einem der Ansprüche 17 bis 19, **dadurch gekennzeichnet, dass** man die Vakuum-Rezipientenwand

- auf Schwebepotential oder

- über ein Impedanzelement an ein Bezugspotential gefesselt betreibt.

**21.** Verfahren nach einem der Ansprüche 1 bis 12, **dadurch gekennzeichnet, dass** man das Werkstück bezüglich Anode der Entladung auf einer Spannung zwischen -25 V und +25 V betreibt, vorzugsweise für Ga-Verbindungen, für Si-, Ge- oder deren Verbindungen, vorzugsweise auf

$$- 20\ V \leq U_s \leq +20V,$$

dabei vorzugsweise auf einer negativen Spannung.

**22.** Verfahren nach einem der Ansprüche 1 bis 21, sofern von Anspruch 1 abhängig, **dadurch gekennzeichnet, dass** man die Werkstücktemperatur zwischen 300°C und 600° hält.

**23.** Verfahren nach einem der Ansprüche 2 bis 21, sofern von Anspruch 2 abhängig, **dadurch gekennzeichnet, dass** die Werkstücktemperatur zwischen 300° und 800°C hält.

**24.** Verfahren nach einem der Ansprüche 1 bis 23, **dadurch gekennzeichnet, dass** man die Beschichtung mit einer Beschichtungsrate pro Reaktivgasfluss-Einheit $GR_F$ vornimmt, welche mindestens 7,5 Å/(sccm.min) beträgt, vorzugsweise mindestens 40 Å/(sccm.min), besonders vorzugsweise mindestens 75 Å/(sccm.min) beträgt.

**25.** Verfahren nach einem der Ansprüche 1 bis 24, **dadurch gekennzeichnet, dass** man erwünschte Beschichtungsratenänderungen durch im Wesentlichen hierzu proportionales Verstellen des Reaktivgasflusses in den Vakuumrezipienten vornimmt.

**26.** Verfahren nach einem der Ansprüche 1 bis 25, **dadurch gekennzeichnet, dass** man erwünschte Beschichtungsratenänderungen durch im wesentlichen hierzu proportionales Verstellen der Entladungs-Stromdichte vornimmt, vorzugsweise durch Verstellung des Entladestromes und/oder der Entladespannung und/oder durch Umlenkung und/oder durch Bündelungsvariation der Entladung bezüglich des Werkstückes, letztere vorzugsweise elektrostatisch und/oder magnetisch.

**27.** Verfahren nach einem der Ansprüche 1 bis 26, **dadurch gekennzeichnet, dass** man über eine Blende eine Kathodenkammer mit mindestens einer Heisskathode an einen Vakuumrezipienten ankoppelt und im Rezipienten einen Werkstückträger sowie eine Anodenanordnung vorsieht, wobei der Werkstückträger elektrisch isoliert im Rezipienten montiert wird.

**28.** Verfahren nach Anspruch 27, **dadurch gekennzeichnet, dass** der Werkstückträger bezüglich der Anode auf einstellbare Spannung gelegt oder potential-schwebend betrieben wird, dabei das Rezipientengehäuse auf Anodenpotential und die Kathode mit Bezug auf Anodenpotential auf kathodisches Potential gelegt werden, vorzugsweise zwischen 10 und 80 V, dabei besonders bevorzugterweise zwischen 20 und 35 V, wobei vorzugsweise der Werkstückträger bezogen auf das Anodenpotential höchstens um ± 25 V verstellbar ist.

**29.** Verfahren nach Anspruch 27 oder 28, **dadurch gekennzeichnet, dass** als Anodenanordnung für die Entladung die Vakuum-Rezipientenwand eingesetzt wird oder die Anodenanordnung im Rezipienten isoliert montiert wird.

**30.** Verfahren nach Anspruch 29, **dadurch gekennzeichnet, dass** der Werkstückträger potential-schwebend betrieben und so angeordnet wird, dass seine Spannung bezüglich der Anodenanordnung sich nicht negativer als -25 V einstellt, vorzugsweise auf -15 V bis -3 V.

**31.** Verfahren nach Anspruch 30, **dadurch gekennzeichnet, dass** der Werkstückträger mittels einer vorzugsweise einstellbaren Bias-Quelle bezüglich der Anodenanordnung auf eine Spannung von - 25 V bis +25 V gelegt wird, vorzugsweise auf eine negative, vorzugsweise von -15 V bis -3 V.

**32.** Verfahren nach einem der Ansprüche 27 bis 31, **dadurch gekennzeichnet, dass** eine Hilfsanode vorgesehen wird, vorzugsweise in Form einer konzentrisch zur Achse der Blende angeordneten Ringanode, die bezüglich Rezipientenwandung auf gleiches oder unterschiedliches Potential gelegt werden kann bzw. gelegt wird.

**33.** Verfahren nach einem der Ansprüche 27 bis 32, **dadurch gekennzeichnet, dass** die Rezipientenwand potential-schwebend betrieben wird oder über ein Impedanzelement, vorzugsweise ein Widerstandselement, an ein Bezugspotential gefesselt.

**34.** Verfahren nach einem der Ansprüche 27 bis 33, **dadurch gekennzeichnet, dass** in die Kathodenkammer von einer mit einem Arbeitsgastank, vorzugsweise einem Argongastank, verbundenen Gaszuführleitung Gas eingelassen wird.

**35.** Verfahren nach einem der Ansprüche 27 bis 34, **dadurch gekennzeichnet, dass** im Wesentlichen konzentrisch zur Blendenachse, eine Magnetanordnung vorgesehen wird zur Erzeugung eines zur Blendenachse koaxialen oder diesbezüglich versetzten Magnetfeldes im Rezipienten, wobei die Magnetanordnung Permanentmagnete und/oder mindestens eine Spulenanordnung umfasst.

**36.** Verfahren nach einem der Ansprüche 27 bis 35, **dadurch gekennzeichnet, dass** der Rezipient an eine Turbovakuumpumpe, vorzugsweise eine Turbomolekularpumpe, angeschlossen wird.

**37.** Verfahren nach einem der Ansprüche 27 bis 36, **dadurch gekennzeichnet, dass** der Werkstückträger am Ort höchster Elektronendichte der Entladung, vorzugsweise im Wesentlichen konzentrisch zur Blendenachse im Rezipienten angeordnet wird.

**38.** Verfahren nach einem der Ansprüche 27 bis 37, **dadurch gekennzeichnet, dass** in den Rezipienten von einer Gastankanordnung ein Si- und/oder Ge-haltiges Gas oder ein Ga-haltiges Gas, vorzugsweise zusätzlich mit H2, eingelassen wird.

**39.** Verfahren nach einem der Ansprüche 1 bis 38, **dadurch gekennzeichnet, dass** man das Werkstück unabhängig von der Entladung heizt.

**40.** Verfahren nach einem der Ansprüche 1 bis 39 für die Herstellung von Werkstücken mit einer Halbleiterschicht.

**41.** Verfahren nach einem der Ansprüche 1 bis 40, sofern von Anspruch 1 abhängend, **dadurch gekennzeichnet, dass** man das Schichtmaterial dotiert mit mindestens einem Element aus den Gruppen III und/oder V des Periodensystems.

**42.** Verfahren nach einem der Ansprüche 2 bis 40, sofern von Anspruch 2 abhängend, **dadurch gekennzeichnet, dass** man das Schichtmaterial dotiert mit mindestens einem Element der Gruppen II, III, IV oder VI des Periodensystems, z.B. mit Mg oder Si.

**43.** Verfahren nach einem der Ansprüche 1 bis 42, **dadurch gekennzeichnet, dass** man als Reaktivgas ein Gas mit Wasserstoffgas in den Reaktionsraum einbringt.

**44.** Verwendung des Verfahrens nach einem der Ansprüche 1 bis 43 in einem Verfahren zur Herstellung von Solarzellen, FET's oder Bipolar-Transistoren.

**Claims**

**1.** Process for the production of workpieces which are coated with a layer containing silicon and/or germanium by means of PECVD in a total pressure range from $10^{-4}$ mbar to $10^{-1}$ mbar (both limit values included) with use of a DC low voltage discharge with a discharge voltage of maximum 80 V, a discharge current between 5 A and 400 A (both values included) and a measured minimum current density of at least 0.05 A/cm$^2$ at the site of the epitaxial layer to be deposited, such that a workpiece temperature of maximum 600°C and a growth rate of at least 30 nm/min is maintained.

**2.** Process for the production of workpieces which are coated with a layer containing gallium, by means of PECVD in a total pressure range from $10^{-4}$ mbar to $10^{-1}$ mbar (both limit values included) with use of a DC low voltage discharge with a discharge voltage of maximum 80 V, a discharge current between 5 A and 400 A (both values included) and a measured minimum current density of at least 0.05 A/cm$^2$ at the site of the epitaxial layer to be deposited, such that a workpiece temperature of maximum 800°C and a growth rate of at least 30 nm/min is maintained.

**3.** Process according to claim 1 or 2, **characterised in that** the coating takes place with a gas utilisation factor of

$$1\% \leq GA_F \leq 90\%.$$

**4.** Process according to claim 1, **characterised in that** the growth rate is

$$GR \geq 600 \text{ Å/min},$$

particularly preferably

$$GR \geq 1000 \text{ Å/min}.$$

**5.** Process according to claim 4, **characterised in** the gas utilisation factor is

$$GA_F \geq 5\%.$$

**6.** Process according to any of claims 1 to 5, **characterised in that** the minimum current density is at least 0.1 A/cm$^2$ up to a density of the maximum discharge current/substrate area.

**7.** Process according to any of claims 1 to 6, **characterised in that** the measured current density is predominantly generated by electron incidence.

**8.** Process according to any of claims 1 to 7, **characterised in that** the discharge current $I_{AK}$ is selected as

$$20 \text{ A} \leq I_{AK} \leq 100 \text{ A}.$$

**9.** Process according to any of claims 1 to 8, **characterised in that** the discharge voltage $U_{AK}$ is selected as

$$10 \text{ V} \leq U_{AK} \leq 80 \text{ V}$$

preferably as

$$20 \text{ V} \leq U_{AK} \leq 35 \text{ V}.$$

**10.** Process according to any of claims 1 to 9, **characterised in that** the reactive gas partial pressure $P_R$ in the process chamber is selected as

$$10^{-5} \text{ mbar} \leq P_R \leq 10^{-1} \text{ mbar}$$

preferably as

$$10^{-4} \text{ mbar} \leq P_R \leq 10^{-2} \text{ mbar}.$$

**11.** Process according to any of claims 1 to 10, **characterised in that** in the process chamber the total pressure $P_T$ is set as follows

$$10^{-3} \text{ mbar} \leq P_T \leq 10^{-2} \text{ mbar.}$$

12. Process according to any of claims 1 to 11, **characterised in that** in the recipient a working gas partial pressure $P_A$ is set as follows:

$$10^{-4} \text{ mbar} \leq P_A \leq 10^{-1} \text{ mbar,}$$

preferably

$$10^{-3} \text{ mbar} \leq P_A \leq 10^{-2} \text{ mbar.}$$

13. Process according to any of claims 1 to 12, **characterised in that** the discharge voltage is applied between the discharge cathode and a vacuum recipient wall laid to a reference potential, preferably earth potential.

14. Process according to claim 13, **characterised in that** in the process chamber the workpiece is

- operated at floating potential or

- laid to a connected bias potential.

15. Process according to claim 13, **characterised in that** the workpiece is operated at a voltage $U_s$ with respect to the discharge anode, which is negative, preferably $U_s \geq -25$ V, preferably between -15 V and -3 V.

16. Process according to any of claims 13 to 15, **characterised in that** along the discharge path an auxiliary anode is provided, preferably in the form of a ring anode surrounding the discharge, which is operated at a preferably adjustable voltage with respect to the discharge cathode, which is preferably not larger than the discharge voltage.

17. Process according to any of claims 1 to 12, **characterised in that** in the vacuum recipient is provided, mounted isolated therefrom, an anode for the discharge, preferably in the form of a ring anode.

18. Process according to claim 17, **characterised in that** the workpiece in the process chamber is laid

- to floating potential or

- to a connected bias potential.

19. Process according to claim 18, **characterised in that** the workpiece with respect to the discharge cathode is operated at most at discharge voltage.

20. Process according to any of claims 17 to 19, **characterised in that** the vacuum recipient wall is operated

- at floating potential or
- tied up via an impedance element to a reference potential.

21. Process according to any of claims 1 to 12, **characterised in that** the workpiece is operated with respect to the discharge anode at a voltage between -25 V and +25 V, preferably for Ga compounds, for Si, Ge or their compounds preferably at

$$-20 \text{ V} \leq U_s \leq +20\text{V,}$$

here preferably at a negative voltage.

22. Process according to any of claims 1 to 21 where dependent on claim 1, **characterised in that** the workpiece temperature is kept between 300°C and 600°C.

23. Process according to any of claims 2 to 21 where dependent on claim 2, **characterised in that** the workpiece temperature is kept between 300°C and 800°C.

24. Process according to any of claims 1 to 23, **characterised in that** the coating is applied with a coating rate per reactive gas flow unit $GR_F$ which is at least 7.5 Å/(sccm.min), preferably at least 40 Å/(sccm.min), particularly preferably at least 75 Å/(sccm.min).

25. Process according to any of claims 1 to 24, **characterised in that** the desired coating rate changes are made by essentially proportional adjustment of the reactive gas flow into the vacuum recipient.

26. Process according to any of claims 1 to 25, **characterised in that** the desired coating rate changes are made by essentially proportional adjustment of the discharge current density, preferably by adjustment of the discharge current and/or discharge voltage and/or by deflection and/or by focus variation of the discharge with respect to the workpiece, the latter preferably electrostatically and/or magnetically.

27. Process according to any of claims 1 to 26, **characterised in that** a cathode chamber with at least one hot cathode is coupled via a diaphragm to a vacuum recipient and in the recipient is mounted a workpiece carrier and an anode arrangement, the workpiece carrier being mounted electrically isolated in the recipient.

28. Process according to claim 27, **characterised in that** the workpiece carrier with respect to the anode is operated on an adjustable voltage or on floating potential, the recipient housing is laid to anode potential and the cathode with respect to the anode potential is laid on cathodic potential, preferably between 10 and 80 V, particularly preferably between 20 and 35 V, where preferably the workpiece carrier with respect to the anode potential is adjustable by maximum ± 25 V.

29. Process according to claim 27 or 28, **characterised in that** the vacuum recipient wall is used as an anode arrangement for discharge or the anode arrangement is mounted isolated in the recipient.

30. Process according to claim 29, **characterised in that** the workpiece carrier is operated on floating potential and is arranged so that its voltage with respect to the anode arrangement becomes not more negative than -25 V, preferably becomes -15 V to -3 V.

31. Process according to claim 30, **characterised in that** the workpiece carrier is laid by means of a preferably adjustable bias source with respect to the anode arrangement to a voltage of -25 V to +25 V, preferably to a negative, preferably from -15 V to -3 V.

32. Process according to any of claims 27 to 31, **characterised in that** an auxiliary anode is provided, preferably in the form of a ring anode arranged concentric to the axis of the diaphragm, which with respect to the recipient wall can be or is laid to the same or to a different potential.

33. Process according to any of claims 27 to 32, **characterised in that** the recipient wall is operated on floating potential or is tied up via an impedance element, preferably a resistance element, to a reference potential.

34. Processes according to any of claims 27 to 33, **characterised in that** gas is introduced into the cathode chamber from a gas supply line connected with a working gas tank, preferably an argon gas tank.

35. Process according to any of claims 27 to 34, **characterised in that** essentially concentric to the diaphragm axis there is provided a magnet arrangement to generate in the recipient a magnetic field co-axial to or offset from the diaphragm axis, where the magnet arrangement comprises permanent magnets and/or at least one coil arrangement.

36. Process according to any of claims 27 to 35, **characterised in that** the recipient is connected to a turbo vacuum pump, preferably a turbomolecular pump.

37. Process according to any of claims 27 to 36, **characterised in that** the workpiece carrier is arranged at the site of maximum electron density of the discharge, preferably essentially concentric to the diaphragm axis in the recipient.

**38.** Process according to any of claims 27 to 37, **characterised in that** into the recipient, from a gas tank arrangement, is introduced a gas containing Si and/or Ge or a gas containing Ga, preferably also with H2.

**39.** Process according to any of claims 1 to 38, **characterised in that** the workpiece is heated independently of the discharge.

**40.** Process according to any of claims 1 to 39 for the production of workpieces with a semi-conductor layer.

**41.** Process according to any of claims 1 to 40, where dependent on claim 1, **characterised in that** the coating material is doped with at least one element from groups III and/or V of the periodic system.

**42.** Process according to any of claims 2 to 40, where dependent on claim 2, **characterised in that** the coating material is doped with at least one element of the groups II, III, IV or VI of the periodic system, e.g. with Mg or Si.

**43.** Process according to any of claims 1 to 42, **characterised in that** as a reactive gas a gas with hydrogen gas is introduced into the reaction chamber.

**44.** Use of the process according to any of claims 1 to 43 in a process for the production of solar cells, FETs or bipolar transistors.

**Revendications**

**1.** Procédé pour fabriquer des pièces qui sont recouvertes d'une couche contenant du silicium et/ou du germanium, par dépôt chimique en phase vapeur avec utilisation d'un plasma dans une zone de pression totale de $10^{-4}$ mbar inclus à $10^{-1}$ mbar inclus et à l'aide d'une décharge basse tension de courant continu avec une tension de décharge de 80 V au maximum, un courant de décharge entre 5 A inclus et 400 A inclus et une densité de courant minimale mesurée d'au moins 0,05 A/cm$^2$ à l'endroit de la couche épitaxiale à déposer, de manière à respecter une température de la pièce de 600°C au maximum et une vitesse de croissance d'au moins 30 nm/min.

**2.** Procédé pour fabriquer des pièces qui sont recouvertes d'une couche contenant du galium, par dépôt chimique en phase vapeur avec utilisation d'un plasma dans une zone de pression totale de $10^{-4}$ mbar inclus à $10^{-1}$ mbar inclus et à l'aide d'une décharge basse tension de courant continu avec une tension de décharge de 80 V au maximum, un courant de décharge entre 5 A inclus et 400 A inclus et une densité de courant minimale mesurée d'au moins 0,05 A/cm$^2$ à l'endroit de la couche épitaxiale à déposer, de manière à respecter une température de la pièce de 800°C au maximum et une vitesse de croissance d'au moins 30 nm/min.

**3.** Procédé selon la revendication 1 ou 2, **caractérisé en ce que** l'application du revêtement se fait avec une densité d'utilisation de gaz

$$1\ \% \leq GA_F \leq 90\ \%.$$

**4.** Procédé selon la revendication 1, **caractérisé en ce que** le taux de croissance est de

$$GR \geq 600\ \text{Å/min},$$

et de préférence

$$GR \geq 1000\ \text{Å/min}.$$

**5.** Procédé selon la revendication 4, **caractérisé en ce que** la densité d'utilisation de gaz est

$$GA_F \geq 5\ \%.$$

**6.** Procédé selon l'une des revendications 1 à 5, **caractérisé en ce que** la densité de courant minimale va d'au moins 0,1 A/cm$^2$ à une densité courant de décharge/surface de substrat, au maximum.

**7.** Procédé selon l'une des revendications 1 à 6, **caractérisé en ce que** la densité de courant mesurée est générée principalement par incidence d'électrons.

**8.** Procédé selon l'une des revendications 1 à 7, **caractérisé en ce qu'**on choisit pour le courant de décharge $I_{AK}$

$$20\,A \leq I_{AK} \leq 100\,A.$$

**9.** Procédé selon l'une des revendications 1 à 8, **caractérisé en ce qu'**on choisit pour la tension de décharge $U_{AK}$

$$10\,V \leq U_{AK} \leq 80\,V,$$

de préférence

$$20\,V \leq U_{AK} \leq 35\,V.$$

**10.** Procédé selon l'une des revendications 1 à 9, **caractérisé en ce qu'**on choisit pour la pression partielle de gaz réactif $P_R$ dans l'espace de traitement

$$10^{-5}\,mbar \leq P_R \leq 10^{-1}\,mbar,$$

de préférence

$$10^{-4}\,mbar \leq P_R \leq 10^{-2}\,mbar.$$

**11.** Procédé selon l'une des revendications 1 à 10, **caractérisé en ce qu'**on règle la pression totale $P_T$ dans l'espace de traitement de la manière suivante :

$$10^{-3}\,mbar \leq P_T \leq 10^{-2}\,mbar.$$

**12.** Procédé selon l'une des revendications 1 à 11, **caractérisé en ce qu'**on règle une pression partielle de gaz de travail $P_A$ dans le récipient de la manière suivante :

$$10^{-4}\,mbar \leq P_A \leq 10^{-1}\,mbar,$$

de préférence

$$10^{-3}\,mbar \leq P_A \leq 10^{-2}\,mbar.$$

**13.** Procédé selon l'une des revendications 1 à 12, **caractérisé en ce qu'**on applique la tension de décharge entre la cathode de décharge et une paroi de récipient à vide mise à un potentiel de référence, de préférence un potentiel de masse.

**14.** Procédé selon la revendication 13, **caractérisé en ce que** la pièce dans l'espace de traitement

- fonctionne à un potentiel flottant ou
- est mise à un potentiel de polarisation.

**15.** Procédé selon la revendication 13, **caractérisé en ce qu'**on fait fonctionner la pièce à une tension $U_s$, par rapport à l'anode de décharge, qui est négative, de préférence $U_s \geq$ -25 V, et qui est située de préférence entre -15 V et -3 V.

**16.** Procédé selon l'une des revendications 13 à 15, **caractérisé en ce qu'**on prévoit, le long de la voie de décharge, une anode auxiliaire, de préférence en forme d'anode annulaire entourant la décharge, et on fait fonctionner cette anode auxiliaire à une tension de préférence réglable, par rapport à la cathode de décharge, qui n'est pas supérieure, de préférence, à la tension de décharge.

**17.** Procédé selon l'une des revendications 1 à 12, **caractérisé en ce qu'**il est prévu dans le récipient à vide une anode qui est isolée par rapport à celui-ci, pour la décharge, et qui a de préférence la forme d'une anode annulaire.

**18.** Procédé selon la revendication 17, **caractérisé en ce que** la pièce dans l'espace de traitement est mise

- à un potentiel flottant ou
- à un potentiel de polarisation.

**19.** Procédé selon la revendication 18, **caractérisé en ce qu'**on fait fonctionner la pièce, par rapport à la cathode de décharge, au maximum à la tension de décharge.

**20.** Procédé selon l'une des revendications 17 à 19, **caractérisé en ce qu'**on fait fonctionner la paroi de récipient à vide

- à un potentiel flottant ou
- en l'asservissant par l'intermédiaire d'une impédance à un potentiel de référence.

**21.** Procédé selon l'une des revendications 1 à 12, **caractérisé en ce qu'**on fait fonctionner la pièce, par rapport à l'anode de la décharge, à une tension située entre -25 V et +25 V, de préférence pour des composés de Ga, pour Si, Ge ou leurs composés, de préférence

$$-20 \text{ V} \leq U_s \leq +20 \text{ V},$$

de préférence à une tension négative.

**22.** Procédé selon l'une des revendications 1 à 21, dans la mesure où elle est dépendante de la revendication 1, **caractérisé en ce qu'**on maintient la température de la pièce entre 300°C et 600°C.

**23.** Procédé selon l'une des revendications 2 à 21, dans la mesure où elle est dépendante de la revendication 2, **caractérisé en ce qu'**on maintient la température de la pièce entre 300°C et 800°C.

**24.** Procédé selon l'une des revendications 1 à 23, **caractérisé en ce qu'**on applique le revêtement à une vitesse par unité de flux de gaz réactif $GR_F$ qui est d'au moins 7,5 Å/(sccm.min), de préférence d'au moins 40 Å/(sccm.min), de préférence d'au moins 75 Å/(sccm.min).

**25.** Procédé selon l'une des revendications 1 à 24, **caractérisé en ce qu'**on procède à des modifications souhaitées de la vitesse d'application de revêtement grâce à un réglage, sensiblement proportionnel, du flux de gaz réactif dans les récipients à vide.

**26.** Procédé selon l'une des revendications 1 à 25, **caractérisé en ce qu'**on procède à des modifications souhaitées de la vitesse d'application de revêtement grâce à un réglage, sensiblement proportionnel, de la densité de courant de décharge, de préférence grâce à un réglage du courant de décharge et/ou de la tension de décharge et/ou grâce à une déviation et/ou à une variation de focalisation de la décharge par rapport à la pièce, de préférence par voie électrostatique et/ou magnétique, dans ce dernier cas.

**27.** Procédé selon l'une des revendications 1 à 26, **caractérisé en ce que** grâce à un diaphragme, on relie une chambre cathodique pourvue d'au moins une cathode chaude à un récipient à vide et on prévoit dans le récipient un porte-pièce ainsi qu'un dispositif formant anode, le porte-pièce étant monté dans le récipient en étant isolé électriquement.

28. Procédé selon la revendication 27, **caractérisé en ce que** le porte-pièce est mis à une tension réglable, par rapport à l'anode, ou fonctionne avec un potentiel flottant, étant précisé que l'enveloppe de récipient est mise au potentiel anodique, et la cathode au potentiel cathodique, par rapport au potentiel anodique, de préférence entre 10 et 80 V, plus spécialement entre 20 et 35 V, et que le porte-pièce est de préférence réglable par rapport au potentiel anodique de ± 25 V, au maximum.

29. Procédé selon la revendication 27 ou 28, **caractérisé en ce qu'**on utilise comme dispositif formant anode pour la décharge la paroi du récipient à vide ou on monte le dispositif formant anode dans le récipient en l'isolant.

30. Procédé selon la revendication 29, **caractérisé en ce qu'**on fait fonctionner le porte-pièce à un potentiel flottant et on le dispose de telle sorte que sa tension par rapport au dispositif formant anode ne se règle pas au-dessous de -25 V, mais de préférence de -15 V à -3 V.

31. Procédé selon la revendication 30, **caractérisé en ce que** le porte-pièce, à l'aide d'une source de polarisation de préférence réglable, est mis par rapport au dispositif formant anode à une tension de -25 V à +25 V, de préférence à une tension négative, de préférence de -15 V à -3 V.

32. Procédé selon l'une des revendications 27 à 31, **caractérisé en ce qu'**il est prévu une anode auxiliaire, de préférence en forme d'anode annulaire concentrique par rapport à l'axe du diaphragme, qui peut être mise ou qui est mise au même potentiel que la paroi du récipient ou à un potentiel différent.

33. Procédé selon l'une des revendications 27 à 32, **caractérisé en ce qu'**on fait fonctionner la paroi du récipient à un potentiel flottant, ou on l'asservit grâce à une impédance, de préférence une résistance, à un potentiel de référence.

34. Procédé selon l'une des revendications 27 à 33, **caractérisé en ce que** du gaz est amené dans la chambre cathodique par une conduite d'amenée de gaz qui est reliée à un réservoir de gaz de travail, de préférence un réservoir d'argon.

35. Procédé selon l'une des revendications 27 à 34, **caractérisé en ce qu'**il est prévu un dispositif magnétique, sensiblement concentrique par rapport à l'axe du diaphragme, pour générer dans le récipient un champ magnétique coaxial ou décalé par rapport à l'axe du diaphragme, le dispositif magnétique comportant des aimants permanents et/ou au moins un dispositif à bobine.

36. Procédé selon l'une des revendications 27 à 35, **caractérisé en ce que** le récipient est relié à un dépresseur à turbine, de préférence une pompe turbomoléculaire.

37. Procédé selon l'une des revendications 27 à 36, **caractérisé en ce que** le porte-pièce est disposé dans le récipient à l'endroit de la densité d'électrons de la décharge maximale, de préférence de manière sensiblement concentrique par rapport à l'axe du diaphragme.

38. Procédé selon l'une des revendications 27 à 37, **caractérisé en ce qu'**un gaz contenant Si et/ou Ge ou un gaz contenant Ga, de préférence avec H2 en supplément, est introduit dans le récipient par un dispositif formant réservoir de gaz.

39. Procédé selon l'une des revendications 1 à 38, **caractérisé en ce qu'**on chauffe la pièce indépendamment de la décharge.

40. Procédé selon l'une des revendications 1 à 39 pour fabriquer des pièces avec une couche semiconductrice.

41. Procédé selon l'une des revendications 1 à 40, dans la mesure où elle est dépendante de la revendication 1, **caractérisé en ce qu'**on dope la matière de la couche avec au moins un élément des groupes III et/ou V de la classification périodique.

42. Procédé selon l'une des revendications 2 à 40, dans la mesure où elle dépend de la revendication 2, **caractérisé en ce qu'**on dope la matière de la couche avec au moins un élément des groupes II, III, IV ou VI de la classification périodique, par exemple Mg ou Si.

**43.** Procédé selon l'une des revendications 1 à 42, **caractérisé en ce qu'**on amène dans l'espace de réaction, comme gaz réactif, un gaz avec de l'hydrogène gazeux.

**44.** Utilisation du procédé selon l'une des revendications 1 à 43 dans un procédé pour fabriquer des cellules solaires, des transistors à effet de champ ou des transistors bipolaires.

FIG.1

FIG.2

FIG.3

FIG.4

FIG.5

FIG.6

FIG.7